# EUROPEAN PATENT SPECIFICATION

(11) **EP 4 071 769 B1**
(45) Date of publication and mention of the grant of the patent: **09.10.2024**
(21) Application number: 20895587.2
(22) Date of filing: 04.12.2020
(51) Int. Cl.: H01B 13/00, H01B 12/04, H01B 12/10

(54) **PRECURSOR FOR NB3SN SINGLE-CORE SUPERCONDUCTING WIRE RODS AND METHOD FOR PRODUCING SAME, NB3SN SINGLE-CORE SUPERCONDUCTING WIRE ROD**
VORLÄUFER FÜR EINKERNIGE SUPRALEITENDE NB3SN-WALZDRÄHTE UND VERFAHREN ZU DEREN HERSTELLUNG, EINKERNIGER SUPRALEITENDER NB3SN-WALZDRAHT
PRÉCURSEUR POUR FILS-MACHINE SUPRACONDUCTEUR À NOYAU UNIQUE DE NB3SN ET SON PROCÉDÉ DE PRODUCTION, FIL-MACHINE SUPRACONDUCTEUR À NOYAU UNIQUE DE NB3SN

(30) Priority: 04.12.2019 JP 2019219948
(43) Date of publication of application: 12.10.2022
(73) Proprietor: FURUKAWA ELECTRIC CO., LTD., Chiyoda-ku Tokyo 100-8322 (JP)
(72) Inventor: ASAMI, Daisuke, Tokyo 100-8322 (JP); KATAYAMA, Kota, Tokyo 100-8322 (JP); SUGIMOTO, Masahiro, Tokyo 100-8322 (JP); II, Hideki, Tokyo 100-8322 (JP); SAKAMOTO, Hisaki, Tokyo 100-8322 (JP); KATO, Tomoya, Tokyo 100-8322 (JP)
(74) Representative: Winter, Brandl - Partnerschaft mbB
(86) International application number: PCT/JP2020/045169
(87) International publication number: WO 2021/112211

(56) References cited:
- WO-A1-2007/102517
- JP-A- 2007 165 151
- JP-A- 2007 165 151
- JP-A- 2010 015 821
- JP-A- S5 871 508
- JP-A- S6 358 716
- JP-A- S62 230 958
- US-A1- 2013 053 250

## Description

### TECHNICAL FIELD

The present invention relates to a precursor for Nb₃Sn single-core superconducting wire according to claim 1 and a method for producing same, an Nb₃Sn single-core superconducting wire, according to claim 6, a precursor for Nb₃Sn multi-core superconducting wire and a method for producing same, and an Nb₃Sn multi-core superconducting wire.

### BACKGROUND ART

Currently, Nb₃Sn superconducting wire made using intermetallic compound Nb₃Sn is being used in superconducting magnets that are used in accelerators, nuclear magnetic resonance apparatuses (NMR), nuclear fusion devices, etc.

For the above-mentioned Nb₃Sn superconducting wire, an Nb₃Sn wire produced by a production method called the bronze process is mainstream. In the bronze process, upon compositing and diameter reducing the Cu-Sn alloy (bronze) and Nb matrix within a billet, Nb₃Sn is generated at the surface of the Nb matrix by heat treating. However, there are many cases where it is not possible to ensure sufficient Nb₃Sn yield due to a limitation in the Sn amount which can be made into solid solution in bronzing, and not being able to obtain a sufficiently high critical current density (Jc). Furthermore, the Cu-Sn alloy is a very hard alloy, and it is necessary to frequently conduct the intermediate annealing process during the diameter reduction processing; therefore, it has a problem also in the production cost and the lead time.

Therefore, in recent years, a production method called internal diffusion process originating from the Nb tube method has been receiving attention. For example, Patent Document 1 discloses a production method of Nb₃Sn multi-core superconducting wire which accommodates a Cu-coated Sn rod or Cu-Sn alloy rod inside of a Cu billet having a plurality of through holes in the axial direction via an Nb pipe which is an Nb-based tube to form a complex, followed by conducting hydrostatic extrusion processing and wire drawing on this complex, and then conducting heat treatment to form the Nb₃Sn. In this method, since there is no limitation on the Sn amount, the yield of Nb₃Sn increases compared to the bronze process, and it is possible to achieve high critical current density (Jc) .

However, with the Nb₃Sn superconducting wire produced in Patent Document 1, so-called tube breakage in which the Nb-based tube is partially damaged during the wire drawing process occurs, and depending on the production conditions, the Nb-based tube may completely break. Not only with breakage of the Nb-based tube, but even in a case of tube cracking of the Nb-based tube, the superconducting characteristic of the superconducting wire declines. For this reason, it has been sought to suppress a decline in the superconducting characteristic caused by such tube cracking or tube breakage.

Patent Document 1: Japanese Unexamined Patent Application, Publication No. H3-283320 Relevant prior art can be found in documents: JP2007165151A, US2013/053250A1 and JP2010015821A.

### DISCLOSURE OF THE INVENTION

### Problems to be Solved by the Invention

An object of the present invention is to provide a precursor for Nb₃Sn single-core superconducting wire for producing a superconducting wire which can suppress tube cracking and tube breakage of Nb-based tube and can suppress a decline in superconducting characteristic, a method for producing the same, an Nb₃Sn single-core superconducting wire, as well as a precursor for Nb₃Sn multi-core superconducting wire, a method for producing the same, and an Nb₃Sn multi-core superconducting wire.

### Means for Solving the Problems

The key components of the present invention are as follows.

A precursor for Nb₃Sn single-core superconducting wire according to claim 1 includes:
a Sn-based wire rod, a first Cu-based tube covering an outer circumferential surface of the Sn-based wire rod, an Nb-based tube covering an outer surface of the first Cu-based tube, and a second Cu-based tube covering an outer surface of the Nb-based tube, in which the Sn-based wire rod contains a matrix phase and at least one kind of hard phase which is harder than the matrix phase, and, in a cross section parallel to a longitudinal direction of the precursor for Nb₃Sn single-core superconducting wire, a maximum dimension of the hard phase in a width direction perpendicular to the longitudinal direction is 50% or less of a minimum dimension in the width direction of the Sn-based wire rod and/or is equal to or smaller than a minimum thickness in the width direction of the Nb-based tube.

According to a second aspect of the present invention, in the precursor for Nb₃Sn single-core superconducting wire as described in the first aspect, the Sn-based wire rod contains a total of 10.0% by mass or less of at least one kind of element selected from the group consisting of Ti, Cu, Hf, Zn, Zr and Al.

According to a third aspect of the present invention, in the precursor for Nb₃Sn single-core superconducting wire as described in the first or second aspect, the maximum dimension of the hard phase in the cross section is 40% or less of the minimum dimension of the Sn-based wire rod.

According to a fourth aspect of the present invention, in the precursor for Nb₃Sn single-core superconducting wire as described in any one of the first to third aspects, the maximum dimension of the hard phase in the cross section is 20% or less of the minimum dimension of the Sn-based wire rod.

According to a fifth aspect of the present invention, in the precursor for Nb₃Sn single-core superconducting wire as described in any one of the first to fourth aspects, in the cross section, a ratio (S_{Nb}/S_{Sn}) of a cross sectional area S_{Nb} of the Nb-based tube relative to a cross sectional area S_{Sn} of the Sn-based wire rod is 2.0 or more and 4.0 or less.

A method for producing a precursor for Nb₃Sn single-core superconducting wire according to claim 6 includes the steps of: forming a first covered wire rod in which a first Cu-based tube covers with an outer circumferential surface of an Sn-based wire rod obtained by drawing a filament-like Sn-based element, made by inserting the filament-like Sn-based element into the first Cu-based tube and then performing wire drawing; obtaining a second covered wire rod by inserting the first covered wire rod into an Nb-based tube; and inserting the second covered wire rod into a second Cu-based tube and then performing wire drawing, in which the Sn-based wire rod contains a matrix phase and at least one kind of hard phase which is harder than the matrix phase, and, in a cross section parallel to a longitudinal direction of the precursor for Nb₃Sn single-core superconducting wire, a maximum dimension of the hard phase in a width direction perpendicular to the longitudinal direction is 50% or less of a minimum dimension in the width direction of the Sn-based wire rod and/or is equal to or smaller than a minimum thickness in the width direction of the Nb-based tube.

An Nb₃Sn single-core superconducting wire according to a seventh aspect of the present invention includes a heating product of the precursor for Nb₃Sn single-core superconducting wire as described in any one of the first to fifth aspects.

A precursor for Nb₃Sn multi-core superconducting wire according to an eighth aspect of the present invention includes: a Cu-based core part made by bundling a plurality of Cu-based wire rods; a multilayer wire rod part by arranging a plurality of the precursors for Nb₃Sn single-core superconducting wire as described in any one of the first to fifth aspects with a plurality of layers over an outer circumferential side of the Cu-based core part; and a third Cu-based tube covering an outer circumference of the multilayer wire rod part.

A method for producing a precursor for Nb₃Sn multi-core superconducting wire according to a ninth aspect of the present invention includes a step of inserting, into a third Cu-based tube, a Cu-based core part made by bundling a plurality of Cu-based wire rods, and a multilayer wire rod part having a plurality of the precursors for Nb₃Sn single-core superconducting wire as described in any one of the first to fifth aspects with a plurality of layers over an outer circumferential side of the Cu-based core part, and then performing wire drawing.

An Nb₃Sn multi-core superconducting wire according to a tenth aspect of the present invention includes a heating product of the precursor for Nb₃Sn multi-core superconducting wire as described in the eighth aspect.

### Effects of the Invention

According to the present invention, it is possible to provide a precursor for Nb₃Sn single-core superconducting wire for producing a superconducting wire which can suppress tube cracking and tube breakage of Nb-based tube and can suppress a decline in superconducting characteristic, a method for producing the same, an Nb₃Sn single-core superconducting wire, as well as a precursor for Nb₃Sn multi-core superconducting wire, a method for producing the same, and an Nb₃Sn multi-core superconducting wire.

### BRIEF DESCRIPTION OF THE DRAWINGS

FIG. 1 is a longitudinal section showing an example of a precursor for Nb₃Sn single-core superconducting wire of an embodiment.
FIG. 2 is a transverse section showing an example of a precursor for Nb₃Sn single-core superconducting wire of an embodiment.
FIG. 3 is a transverse section showing an example of a precursor for Nb₃Sn multi-core superconducting wire of an embodiment.

### PREFERRED MODE FOR CARRYING OUT THE INVENTION

Hereinafter, the present invention will be explained in detail based on embodiments.

The present inventors, as a result of thorough investigation, found that, by attempting optimization of the configuration of a Sn-based wire rod (Sn-based material) and an Nb-based tube constituting a precursor for superconducting wire, tube cracking and tube breakage of the Nb-based tube is suppressed, thereby arriving at completing the present invention based on this knowledge.

A precursor for Nb₃Sn single-core superconducting wire of an embodiment includes: a Sn-based wire rod, a first Cu-based tube covering an outer circumferential surface of the Sn-based wire rod, an Nb-based tube covering an outer surface of the first Cu-based tube, and a second Cu-based tube covering an outer surface of the Nb-based tube, in which the Sn-based wire rod contains a matrix phase and at least one kind of hard phase which is harder than the matrix phase, and, in a cross section parallel to a longitudinal direction of the precursor for Nb₃Sn single-core superconducting wire, a maximum dimension of the hard phase in a width direction perpendicular to the longitudinal direction is 50% or less of a minimum dimension in the width direction of the Sn-based wire rod and/or is equal to or smaller than a minimum thickness in the width direction of the Nb-based tube.

A method for producing a precursor for Nb₃Sn single-core superconducting wire of an embodiment includes the steps of: forming a first covered wire rod in which a first Cu-based tube covers with an outer circumferential surface of an Sn-based wire rod obtained by drawing a filament-like Sn-based element, made by inserting the filament-like Sn-based element into the first Cu-based tube and then performing wire drawing; obtaining a second covered wire rod by inserting the first covered wire rod into an Nb-based tube; and inserting the second covered wire rod into a second Cu-based tube and then performing wire drawing, in which the Sn-based wire rod contains a matrix phase and at least one kind of hard phase which is harder than the matrix phase, and, in a cross section parallel to a longitudinal direction of the precursor for Nb₃Sn single-core superconducting wire, a maximum dimension of the hard phase in a width direction perpendicular to the longitudinal direction is 50% or less of a minimum dimension in the width direction of the Sn-based wire rod and/or is equal to or smaller than a minimum thickness in the width direction of the Nb-based tube.

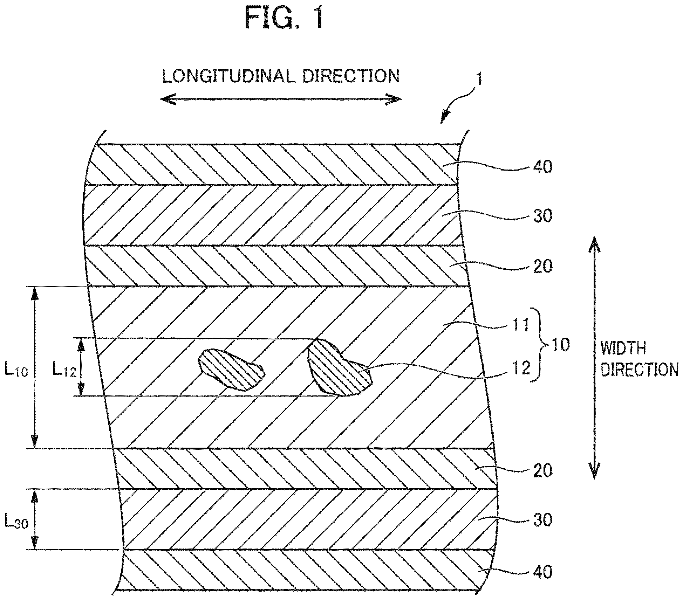

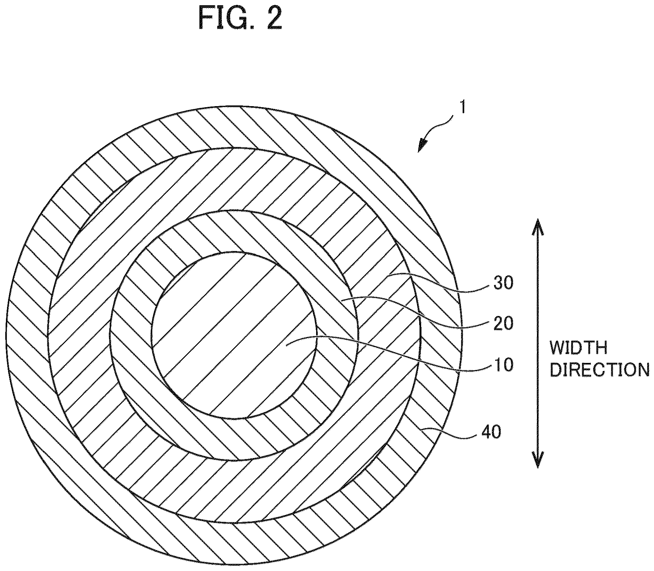

FIG. 1 is a longitudinal section showing an example of a precursor for Nb₃Sn single-core superconducting wire of the present embodiment, and FIG. 2 is a transverse section showing an example of the precursor for Nb₃Sn single-core superconducting wire. It should be noted that a hard phase 12 is omitted for convenience from FIG. 2.

As shown in FIGS. 1 and 2, the precursor 1 for Nb₃Sn single-core superconducting wire of the embodiment includes a Sn-based wire rod 10, a cylindrical first Cu-based tube 20 covering the outer circumferential surface of the Sn-based wire rod 10, a cylindrical Nb-based tube 30 covering the outer surface of the first Cu-based tube 20, and a cylindrical second Cu-based tube 40 covering the outer surface of the Nb-based tube 30.

The Sn-based wire rod 10 is extended along the central axis of the precursor 1 for Nb₃Sn single-core superconducting wire. The shape of the Sn-based wire rod 10 is a cylindrical column shown in FIG. 2 or a prismatic column such as a hexagonal column, for example. The Sn-based wire rod 10 is not powder form.

As shown in FIG. 1, the Sn-based wire rod 10 includes a Sn-based matrix phase 11, and at least one kind of Sn-based hard phase 12 which is harder than the matrix phase 11. In the longitudinal section, which is the cross section parallel to the longitudinal direction of the precursor 1 for Nb₃Sn single-core superconducting wire, the maximum dimension L₁₂ in the width direction of the hard phase 12 is 50% or less of the minimum dimension L₁₀ in the width direction of the Sn-based wire rod 10. In the longitudinal section of the precursor for Nb₃Sn single-core superconducting wire 1, which is a drawn wire, the width direction is perpendicular to the longitudinal direction. The longitudinal section of the precursor 1 for Nb₃Sn single-core superconducting wire is a plane including the central axis of the Sn-based wire rod 10.

Herein, the influence of the hard phase 12 on the Nb-based tube 30 in the precursor for Nb₃Sn single-core superconducting wire, upon wire drawing during the production of the precursor for Nb₃Sn single-core superconducting wire, will be explained.

The Sn-based wire rod 10 is formed by wire drawing a filament-like Sn-based element. As described later, the Sn-based element in the first Cu-based tube 20 is wire drawn to form the Sn-based wire rod 10 by inserting the filament-like Sn-based element in the first Cu-based tube 20, the Nb-based tube 30 and the second Cu-based tube 40 and then wire drawing.

For example, in the case of the Sn-based wire rod 10 or the Sn-based element being Sn alloy containing a trace amount of Cu, the hard phase 12 is a Cu₆Sn₅ phase called the η phase, and the matrix phase 11 has greater Sn content and less Cu content than the hard phase 12. In addition, in the case of the Sn-based wire rod 10 or the Sn-based element being pure Sn, depending on the production conditions and environment of the Sn-based wire rod 10 or the Sn-based element, the impurities mixed during production may become the hard phase 12 or the impurities and Sn react, whereby the hard phase 12 may precipitate. Such a hard phase 12 has high brittleness, and is very hard compared to the matrix phase 11. For this reason, even in the wire drawing of the Sn-based wire rod 10 or the Sn-based element, the size of the hard phase 12, e.g., the dimension in the width direction of the hard phase 12 in the longitudinal section (external dimension), does not change.

On the other hand, by wire drawing, the sizes of the matrix phase 11 of the Sn-based wire rod 10 or the Sn-based element, the first Cu-based tube 20, the Nb-based tube 30 and the second Cu-based tube 40 decrease, for example, the dimension in the width direction of the matrix phase 11 in the longitudinal section, and the thickness dimensions in the width direction of the first Cu-based tube 20, the Nb-based tube 30 and the second Cu-based tube 40 become smaller.

In this way, as performing wire drawing, the dimension in the width direction of the matrix phase 11, and the thickness dimensions in the width direction of the first Cu-based tube 20, the Nb-based tube 30 and the second Cu-based tube 40 become smaller, while the dimension in the width direction of the hard phase 12 does not change. In other words, as performing wire drawing, the dimension of the hard phase 12 becomes relatively large in relation to the dimensions of the matrix phase 11, the first Cu-based tube 20, the Nb-based tube 30 and the second Cu-based tube 40.

Then, in the case of the precursor 1 for Nb₃Sn single-core superconducting wire produced by wire drawing until the dimension in the width direction of the Sn-based element becomes no more than a predetermined value, i.e., in the case of the maximum dimension L₁₂ in the width direction of the hard phase 12 in the longitudinal section of the precursor 1 for Nb₃Sn single-core superconducting wire being greater than 50% of the minimum dimension L₁₀ in the width direction of the Sn-based wire rod 10, the hard phase of the precursor for Nb₃Sn single-core superconducting wire pierces through the first Cu-based tube 20, and contacts the thinned Nb-based tube 30. At the contact part between the hard phase and the Nb-based tube, tube cracking of the Nb-based tube may occur, and depending on the case, partial cracking of the Nb-based tube occurs, and the Nb-based tube completely breaks depending on the state of the contact part.

In the case of producing an Nb₃Sn single-core superconducting wire or an Nb₃Sn multi-core superconducting wire using the precursor for Nb₃Sn single-core superconducting wire accompanying such tube cracking or tube breakage, when the precursor for Nb₃Sn single-core superconducting wire accompanying such tube cracking or tube breakage is heat treated, starting from the portion at which the Nb-based tube is broken, the Sn component of the Sn-based wire rod diffuses to the second Cu-based tube that covers the Nb-based tube from the outer side, and may undergo bronzing. In the Nb₃Sn single-core superconducting wire or the Nb₃Sn multi-core superconducting wire, if the second Cu-based tube on the outer side of the Nb-based tube bronzes, the superconducting characteristic such as residual resistance ratio (RRR) drastically declines in the Nb₃Sn single-core superconducting wire or the Nb₃Sn multi-core superconducting wire. In addition, if the tube cracking or the tube breakage occurs, the Nb₃Sn which is the superconductive material formed by heat treatment is partially or completely divided at the portion at which the tube cracking occurred; therefore, in the Nb₃Sn single-core superconducting wire or the Nb₃Sn multi-core superconducting wire, the critical current density (Jc) also drastically declines.

From the viewpoint of suppressing the declines in the residual resistance ratio and the critical current density from the tube cracking or the tube breakage, in the longitudinal section of the precursor for Nb₃Sn single-core superconducting wire 1, the maximum dimension L₁₂ in the width direction of the hard phase 12 is 50% or less of the minimum dimension L₁₀ in the width direction of the Sn-based wire rod 10, preferably 40% or less of the minimum dimension L₁₀, and more preferably 20% or less of the minimum dimension L₁₀.

In addition, in the precursor for Nb₃Sn single-core superconducting wire, even in the case of the hard phase 12 piercing the first Cu-based tube 20 and contacting with the thinned Nb-based tube 30, if the hard phase 12 is sufficiently small relative to the thickness of the Nb-based tube 30, i.e. if the maximum dimension L₁₂ in the width direction of the hard phase 12 is equal to or smaller than the minimum thickness L₃₀ in the width direction of the Nb-based tube 30 in the longitudinal section, the occurrence of the tube cracking or the tube breakage of the Nb-based tube at the contact part between the hard phase and the Nb-based tube is suppressed. As a result thereof, with the obtained Nb₃Sn single-core superconducting wire or Nb₃Sn multi-core superconducting wire, declines in the residual resistance ratio and the critical current density are suppressed.

On the other hand, in the longitudinal section of the precursor 1 for Nb₃Sn single-core superconducting wire, when the maximum dimension L₁₂ in the width direction of the hard phase 12 is greater than the minimum thickness L₃₀ in the width direction of the Nb-based tube 30, the tube cracking or the tube breakage of the Nb-based tube occurs at the contact part between the hard phase and the Nb-based tube. For this reason, the residual resistance ratio and the critical current density decline.

From the viewpoint of suppressing the declines in the residual resistance ratio and the critical current density due to the tube cracking or the tube breakage, in the longitudinal section of the precursor for Nb₃Sn single-core superconducting wire 1, the maximum dimension L₁₂ in the width direction of the hard phase 12 is equal to or smaller than the minimum thickness L₃₀ in the width direction of the Nb-based tube 30, preferably 70% or less of the minimum thickness L₃₀, and more preferably 50% or less of the minimum thickness L₃₀.

In this way, regarding the precursor 1 for Nb₃Sn single-core superconducting wire which is the drawn wire, in the precursor 1 for Nb₃Sn single-core superconducting wire controlling the maximum dimension L₁₂ in the width direction of the hard phase 12 relative to the Sn-based wire rod 10 to within a predetermined range, the tube cracking and the tube breakage are suppressed. In addition, in the precursor 1 for Nb₃Sn single-core superconducting wire controlling the maximum dimension L₁₂ in the width direction of the hard phase 12 relative to the Nb-based tube 30 to within a predetermined range, the tube cracking and the tube breakage are suppressed. Furthermore, in the precursor 1 for Nb₃Sn single-core superconducting wire controlling the maximum dimension L₁₂ in the width direction of the hard phase 12 relative to the Sn-based wire rod 10 and to the Nb-based tube 30 to within a predetermined range, due to the tube cracking and the tube breakage being further suppressed, the declines in the residual resistance ratio and the critical current density are also further suppressed.

The size of the hard phase 12 such as the maximum dimension L₁₂ in the width direction and the number of the hard phases 12 can be appropriately controlled by adjusting the molten metal temperature during casting of the Sn-based element, the production environment of the Sn-based wire rod 10 and the Sn-based element, etc. For example, if setting the molten metal temperature slightly higher than the melting point of the Sn-based element, the size of the hard phase 12 declines. In addition, even if adjusting the type or the amount of the added components contained in the Sn-based wire rod 10 or the Sn-based element, the size and the number of the hard phases 12 can be controlled.

In addition, the Sn-based wire rod 10 preferably contains at least one kind of element selected from the group consisting of Ti, Cu, Hf, Zn, Zr and Al in a total of 10.0% by mass or less. If the Sn-based wire rod 10 contains 0.5% by mass or more in total of the above-mentioned element(s), the residual resistance ratio and the critical current density of the Nb₃Sn as a superconducting material generated by heating the precursor 1 for Nb₃Sn single-core superconducting wire increase. In addition, by containing the above-mentioned element(s) in the Sn-based wire rod 10 (Sn-based element), since stretch of the Sn-based wire rod 10 (Sn-based element) is suppress to promote work hardening, the wire drawability during multi-core wire processing improves. On the other hand, in the case of containing more than 10.0% by mass of the above-mentioned element(s), since the dimension and the number of the hard phases 12 in the Sn-based wire rod 10 increase, the tube cracking and the tube breakage may tend to occur. For this reason, the total content of the above-mentioned element(s) is preferably 0.5% by mass or more and 10.0% by mass or less, and more preferably 1.5% by mass or more and 5.0% by mass or less.

In addition, as shown in FIG. 1, in the longitudinal section of the precursor 1 for Nb₃Sn single-core superconducting wire, the ratio (S_{Nb}/S_{Sn}) of the cross sectional area S_{Nb} of the Nb-based tube 30 relative to the cross sectional area S_{Sn} of the Sn-based wire rod 10 is preferably 2.0 or more and 4.0 or less.

If the ratio (S_{Nb}/S_{Sn}) is smaller than 2.0, upon generating the Nb₃Sn which is the superconducting component, the amount of Sn component relative to the amount of Nb component will become excessive. For this reason, even in the case of the tube cracking or the tube breakage of the Nb-based tube 30 not occurring, the Sn component of the Sn-based wire rod diffuses to the second Cu-based tube arranged outside of the Nb-based tube by the heat treatment during the producing of the Nb₃Sn single-core superconducting wire or the Nb₃Sn multi-core superconducting wire, and the second Cu-based tube may react with the Sn component to undergo bronzing. Since the second Cu-based tube, which is a stabilizing material, is contaminated by the Sn component in this way, the residual resistance ratio of the Nb₃Sn single-core superconducting wire or the Nb₃Sn multi-core superconducting wire declines.

If the ratio (S_{Nb}/S_{Sn}) is greater than 4.0, upon generating the Nb₃Sn, the amount of Sn component relative to the amount of Nb component becomes extremely small, and it may accompany a decline in the yield of Nb₃Sn obtained by the heat treatment during the production of the Nb₃Sn single-core superconducting wire or the Nb₃Sn multi-core superconducting wire, and a large deviation in the Nb/Sn ratio relative to the stoichiometric ratio of Nb₃Sn. For this reason, the critical current density of the Nb₃Sn single-core superconducting wire or the Nb₃Sn multi-core superconducting wire declines.

For this reason, from the viewpoint of suppressing declines in the residual resistance ratio and the critical current density, the lower limit value for the ratio (S_{Nb}/S_{Sn}) is preferably 2.0, more preferably 2.3, and even more preferably 2.5, and the upper limit value for the ratio (S_{Nb}/S_{Sn}) is preferably 4.0, more preferably 3.7, and even more preferably 3.5.

As described above, the Sn-based wire rod 10 and the Sn-based element are configured from an Sn-based metal material such as Sn alloy or pure Sn. Pure Sn is an Sn-based material having a purity of 99.9% or more.

In addition, the first Cu-based tube 20 is configured from a Cu-based metal material such as Cu alloy or pure Cu. The Cu purity of the pure Cu is preferably 99.9% or more, and more preferably 99.99% or more.

In addition, the Nb-based tube 30 is configured from an Nb-based metal material such as Nb alloy or pure Nb. The pure Nb is an Nb-based material having a purity of 99.99% or more.

In addition, the second Cu-based tube 40 is configured from a Cu-based metal material such as Cu alloy or pure Cu. The second Cu-based tube 40 may be configured from a different material from the first Cu-based tube 20, or may be configured from the same material of the first Cu-based tube 20.

In addition, the shape of the precursor 1 for Nb₃Sn single-core superconducting wire is not particularly limited, and may be cylindrical shape such as that shown in FIGS. 1 and 2, or may be a prismatic shape such as a hexagonal cylinder shape.

Next, a production method of the precursor for Nb₃Sn single-core superconducting wire of the embodiment will be explained. The production method of the precursor for Nb₃Sn single-core superconducting wire of the embodiment includes a step of forming a first covered wire rod by inserting a filament-like Sn-based element into the first Cu-based tube and then performing wire drawing (Step A1); a step of inserting the first covered wire rod into the Nb-based tube to obtain a second covered wire rod after the Step A1 (Step A2); and a step of inserting the second covered wire rod into the second Cu-based tube and then performing wire drawing after the Step A2 (Step A3). For the precursor for Nb₃Sn single-core superconducting wire which is the drawn wire obtained in this way, the Sn-based wire rod in the Nb-based tube includes the matrix phase, and at least one kind of hard phase which is harder than the matrix phase. In addition, in the longitudinal section of the precursor for Nb₃Sn single-core superconducting wire, the maximum dimension in the width direction of the hard phase is 50% or less of the minimum dimension in the width direction of the Sn-based wire rod and/or is equal to or smaller than the minimum thickness in the width direction of the Nb-based tube.

In Step A1, the filament-like Sn-based element containing the above-mentioned matrix phase and hard phase is inserted into the first Cu-based tube and then wire drawn to form the first covered wire rod. With the obtained first covered wire rod, the first Cu-based tube covers the outer circumferential face of the Sn-based wire rod made by wire drawing the Sn-based element. The method of wire drawing is not particularly limited and, for example, is performed using wire drawing die.

In Step A2, the second covered wire rod is obtained by inserting the first covered wire rod obtained in Step A1 into the Nb-based tube. In the second covered wire rod, the first covered wire rod is accommodated in the Nb-based tube.

In Step S3, the second covered wire rod obtained in Step A2 is inserted in the second Cu-based tube and then wire drawn. The precursor 1 for Nb₃Sn single-core superconducting wire shown in FIGS. 1 and 2 is obtained in this way. Similarly to as described above, the method of wire drawing is not particularly limited and, for example, is performed using wire drawing die.

Next, an Nb₃Sn single-core superconducting wire of the embodiment will be explained. The Nb₃Sn single-core superconducting wire of the embodiment is the heating product of the above-mentioned precursor for Nb₃Sn single-core superconducting wire.

For the heat treatment of the precursor for Nb₃Sn single-core superconducting wire, in the case of setting the heating temperature to less than 600°C, the amount of Nb₃Sn produced is small, and the Nb/Sn ratio of the product compound greatly deviates from the stoichiometric ratio; therefore, the critical current density Jc declines. On the other hand, in the case of setting the heating temperature to more than 800°C, due to the crystal grains of the produced Nb₃Sn coarsening, the pinning force of the superconducting wire declines, a result of which the critical current density Jc declines. In addition, since the diffusional reaction of Sn increases, Sn diffuses to the second Cu-based tube arranged at the outer side of the Nb-based tube upon the heat treating, and the residual resistance ratio RRR drastically declines. Therefore, in the heat treatment of the precursor for Nb₃Sn single-core superconducting wire, it is good setting the heating temperature to 600°C or more and 800°C or less, and preferably the range of 650°C or more and 730°C or less.

In addition, for the heating time of the precursor for Nb₃Sn single-core superconducting wire at the above-mentioned heat treatment temperature, in the case of setting the heating time to less than 24 hours, the amount of Nb₃Sn produced is small, and the critical current density Jc declines. In addition, in the case of setting the heating time to more than 500 hours, due to coarsening of the Nb₃Sn crystal grains, and Sn diffusing to the second Cu-based tube on the outer side of the Nb-based tube, the critical current density Jc and the residual resistance ratio RRR decline. Therefore, it is good performing the heat treatment of the precursor for Nb₃Sn single-core superconducting wire with the heating time of 24 hours or more and 500 hours or less, and preferably the range of 100 hours or more and 300 hours or less.

The heat treatment of the precursor for Nb₃Sn single-core superconducting wire, for example, is performed under an atmosphere prepared conducting atmosphere control such as under an argon or nitrogen atmosphere.

By heating the above-mentioned precursor for Nb₃Sn single-core superconducting wire at such conditions, the Nb₃Sn single-core superconducting wire which is the heating product of the precursor for Nb₃Sn single-core superconducting wire is obtained.

Next, a precursor for Nb₃Sn multi-core superconducting wire of the embodiment will be explained.

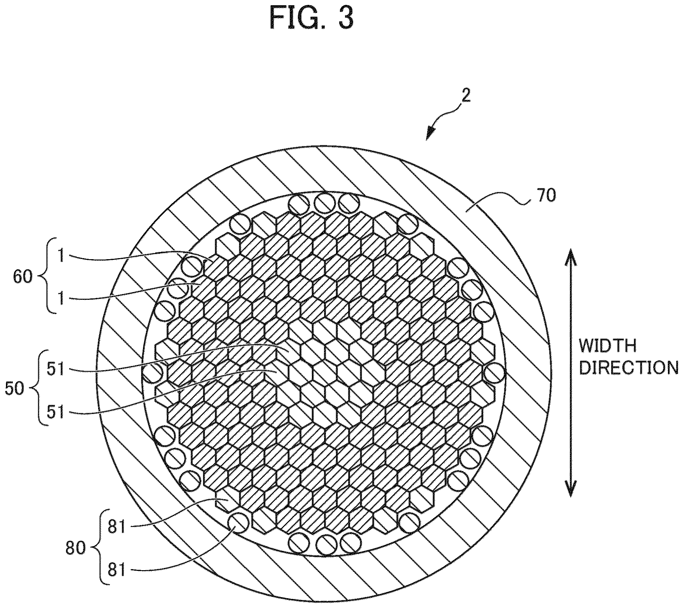

FIG. 3 is a transverse section showing an example of the precursor for Nb₃Sn multi-core superconducting wire of the embodiment. It should be noted that, similarly to FIG. 2, the hard phase 12 is omitted for convenience in FIG. 3.

As shown in FIG. 3, a precursor 2 for Nb₃Sn multi-core superconducting wire of the embodiment includes a Cu-based core part 50, a multilayer wire rod part 60 provided at the outer circumference of the Cu-based core part 50, and a cylindrical third Cu-based tube 70 covering the outer circumference of the multilayer wire rod part 60.

The Cu-based core part 50 is made by bundling a plurality of Cu-based wire rods 51. The Cu-based core part 50 is extended along the central axis of the precursor 2 for Nb₃Sn multi-core superconducting wire. The shapes of the Cu-based core part 50 and the Cu-based wire rod 51, for example, are prismatic columns such as a hexagonal column shown in FIG. 3, or a cylindrical column.

The Cu-based wire rod 51 is configured from a Cu-based metal material such as a Cu alloy or pure Cu. The Cu-based wire rod 51 may be configured from a material different from the first Cu-based tube 20 or the second Cu-based tube 40, or may be configured from the same material as these. In addition, a part or the entirety of the Cu-based wire rod 51 constituting the Cu-based core part 50 may be the precursor 1 for Nb₃Sn single-core superconducting wire. From the viewpoint of the superconducting characteristic, copper ratio design, etc. of the precursor 2 for Nb₃Sn multi-core superconducting wire or the Nb₃Sn multi-core superconducting wire, it is possible to replace the Cu-based wire rod 51 with the precursor 1 for Nb₃Sn single-core superconducting wire.

The number of Cu-based wire rods 51 constituting the Cu-based core part 50 is set as appropriate according to the copper ratio design of the precursor 2 for Nb₃Sn multi-core superconducting wire. In addition, the dimension in the width direction of the Cu-based wire rod 51 is preferably the same as the precursor 1 for Nb₃Sn single-core superconducting wire, from the assembly ease of the precursor 2 for Nb₃Sn multi-core superconducting wire. In addition, from the viewpoint of an improvement in wire drawing processability, the bundled state of the plurality of Cu-based wire rods 51 is preferably a close-packed structure in the transverse section of the precursor 2 for Nb₃Sn multi-core superconducting wire.

In addition, the multilayer wire rod part 60 is made by bundling a plurality of the precursors 1 for Nb₃Sn single-core superconducting wire, and is arranged so as to surround the outer circumferential side of the Cu-based core part 50 by the plurality of the precursors 1 for Nb₃Sn single-core superconducting wire with a plurality of layers. In the transverse section of the precursor 2 for Nb₃Sn multi-core superconducting wire, the multilayer wire rod part 60 has a multilayer structure in which a plurality of layers of the precursor 1 for Nb₃Sn single-core superconducting wire made by arranging a plurality of the precursors 1 for Nb₃Sn single-core superconducting wire over the entire circumference in the circumferential direction of the Cu-based core part 50 is laminated along a direction distancing from the outer circumference of the Cu-based core part 50.

The number of precursors 1 for Nb₃Sn single-core superconducting wire constituting the multilayer wire rod part 60 and the number of layers are set as appropriate according to the superconducting characteristic and the copper ratio design of the precursor 2 for Nb₃Sn multi-core superconducting wire. In addition, from the viewpoint of an improvement in wire drawing workability, the arrangement state of the plurality of precursors 1 for Nb₃Sn single-core superconducting wire is preferably a close-packed structure in the transverse section of the precursor 2 for Nb₃Sn multi-core superconducting wire.

In addition, the third Cu-based tube 70 is provided at the outer circumference of the multilayer wire rod part 60, and covers the multilayer wire rod part 60 from the outside.

The third Cu-based tube 70 is configured from Cu-based metal material such as Cu alloy or pure Cu. The third Cu-based tube 70 may be configured from a different material from the first Cu-based tube 20, the second Cu-based tube 40 and the Cu-based wire rod 51, or may be configured from the same material as these.

In addition, the precursor 2 for Nb₃Sn multi-core superconducting wire preferably includes a Cu-based spacer part 80 between the multilayer wire rod part 60 and the third Cu-based tube 70, as shown in FIG. 3. The Cu-based spacer part 80 is configured from a plurality of the Cu-based wire rods 81. The plurality of Cu-based wire rods 81, in a transverse section of the precursor 2 for Nb₃Sn multi-core superconducting wire, is arranged over the circumferential direction of the multilayer wire rod part 60, between the outer side of the multilayer wire rod part 60 and the inner side of the third Cu-based tube 70.

In addition, regarding the Cu-based spacer part 80, it may be a single-layer spacer arranging a plurality of the Cu-based wire rods 81 in one layer over the circumferential direction of the multilayer wire rod part 60 as shown in FIG. 3, or may be a multi-layer spacer arranging a plurality of the Cu-based wire rods 81 in a plurality of layers along the circumferential direction of the multilayer wire rod part 60.

When the precursor 2 for Nb₃Sn multi-core superconducting wire includes the Cu-based spacer 80, since the packing ratio in the third Cu-based tube 70 of the precursor 2 for Nb₃Sn multi-core superconducting wire increases, when producing the Nb₃Sn multi-core superconducting wire, displacement of the precursors 1 for Nb₃Sn single-core superconducting wire in the third Cu-based tube 70 is suppressed. In addition, if providing the Cu-based spacer 80 between the multilayer wire rod part 60 and the third Cu-based tube 70, the Cu-based spacer 80 serves as a buffer material, and can suppress the precursors 1 for Nb₃Sn single-core superconducting wire located at an outside portion of the multilayer wire rod part 60 from abnormally deforming.

In the transverse section of the precursor 2 for Nb₃Sn multi-core superconducting wire, the Cu-based wire rods 81 may be close together along the circumferential direction of the multilayer wire rod part 60, or may be arranged with intervals as shown in FIG. 3. According to the filling rate inside of the third Cu-based tube 70 or the buffering effect of the Cu-based spacer part 80 as the mentioned above, the arrangement state of the Cu-based wire rods 81 is set as appropriate.

The shape of the Cu-based wire rod 81 is a prismatic shape such as a hexagonal cylinder shape shown in FIG. 3, or a cylindrical column shape, for example, or may be one type of shape, or two or more shapes may be mixed. In the case of the Cu-based spacer part 80 in which hexagonal cylinder shaped Cu-based wire rods 81 and cylindrical column shaped Cu-based wire rods 81 having a smaller width direction dimension than the hexagonal cylinder shape are mixed, inside of the third Cu-based tube 70, since it is possible to insert the cylindrical column shaped Cu-based wire rod having a smaller transverse sectional area than the hexagonal cylindrical shape into the small interval through which the hexagonal cylindrical shaped Cu-based wire rod cannot be inserted, the filling rate inside of the third Cu-based tube 70 increases.

The Cu-based wire rod 81 is configured from a Cu-based metal material such as Cu alloy or pure Cu. The Cu-based wire rod 81 may be configured from a different material from the first Cu-based tube 20, the second Cu-based tube 40, the Cu-based wire rod 51 and the third Cu-based tube 70, or may be configured from the same material as these.

Next, a production method of the precursor for Nb₃Sn multi-core superconducting wire of the embodiment will be explained. The production method of the precursor for Nb₃Sn multi-core superconducting wire of the embodiment includes a step B1 of inserting the Cu-based core part made by bundling a plurality of Cu-based wire rods, and the multilayer wire rod part having a plurality of the above-mentioned precursors for Nb₃Sn single-core superconducting wire at the outer circumferential side of the Cu-based core part into the third Cu-based tube and then wire drawing. For each precursor for Nb₃Sn single-core superconducting wire constituting the precursor for Nb₃Sn multi-core superconducting wire which is the drawn wire obtained in this way, similarly to the above-mentioned precursor for Nb₃Sn single-core superconducting wire, the maximum dimension in the width direction of the hard phase is 50% or less of the minimum dimension in the width direction of the Sn-based wire rod and/or is equal to or smaller than the minimum thickness in the width direction of the Nb-based tube in a longitudinal section of the precursor for Nb₃Sn multi-core superconducting wire.

In Step B1, the multilayer wire rod part made by arranging the Cu-based core part, and the multilayer wire rod part made by arranging a plurality of precursors for Nb₃Sn single-core superconducting wire with a plurality of layers so as to surround the outer circumference of the Cu-based core part are inserted in the third Cu-based tube and wire drawn. Furthermore, as necessary, a plurality of Cu-based wire rods constituting the Cu-based spacer part is inserted between the outer side of the multilayer wire rod part and the inner side of the third Cu-based tube. The precursor 2 for Nb₃Sn multi-core superconducting wire shown in FIG. 3 is obtained in this way. The method of wire drawing is not particularly limited, and is performed using wire drawing die, for example.

Next, an Nb₃Sn multi-core superconducting wire of the embodiment will be explained. The Nb₃Sn multi-core superconducting wire of the embodiment is a heating product of the above-mentioned precursor for Nb₃Sn multi-core superconducting wire.

Regarding the heat treatment of the precursor for Nb₃Sn multi-core superconducting wire, in the case of setting the heating temperature to less than 600°C, the amount of Nb₃Sn produced is small, and the Nb/Sn ratio of the produced compound greatly deviates from the stoichiometric ratio; therefore, the critical current density Jc declines. On the other hand, in the case of setting the heating temperature to more than 800°C, due to the crystal grains of the produced Nb₃Sn coarsening, the pinning force of the superconducting wire declines, a result of which the critical current density Jc declines. In addition, since the diffusional reaction of Sn increases, Sn diffuses to the second Cu-based tube arranged at the outer side of the Nb-based tube upon the heat treating, and the residual resistance ratio RRR drastically declines. Therefore, in the heat treatment of the precursor for Nb₃Sn multi-core superconducting wire, it is good setting the heating temperature to 600°C or more and 800°C or less, and preferably the range of 650°C or more and 730°C or less.

In addition, for the heating time of the precursor for Nb₃Sn multi-core superconducting wire at the above-mentioned heat treatment temperature, in the case of setting the heating time to less than 24 hours, the amount of Nb₃Sn produced is small, and the critical current density Jc declines. In addition, in the case of setting the heating time to more than 500 hours, due to coarsening of the Nb₃Sn crystal grains, and Sn diffusing to the second CU-based tube on the outer side of the Nb-based tube, the critical current density Jc and the residual resistance ratio RRR decline. Therefore, it is good performing the heat treatment of the precursor for Nb₃Sn multi-core superconducting wire with the heating time of 24 hours or more and 500 hours or less, and preferably the range of 100 hours or more and 300 hours or less.

By heating the above-mentioned precursor for Nb₃Sn multi-core superconducting wire at such conditions, the Nb₃Sn multi-core superconducting wire which is the heating product of the precursor for Nb₃Sn multi-core superconducting wire is obtained.

The Nb₃Sn single-core superconducting wire or the Nb₃Sn multi-core superconducting wire produced by the above such Nb tube method can be appropriately used in an Nb₃Sn superconducting wire constituting a superconducting magnet used in an accelerator, nuclear fusion device, nuclear magnetic resonance spectrometer or the like.

According to the above explained embodiments, by attempting optimization of the configuration of the Sn-based wire rod (Sn-based element) or the Nb-based tube constituting the precursor for Nb₃Sn single-core superconducting wire, it is possible to obtain a precursor for Nb₃Sn single-core superconducting wire superior in wire drawing property during the production of Nb₃Sn single-core superconducting wire and Nb₃Sn multi-core superconducting wire. In this way, with the Nb₃Sn single-core superconducting wire or the Nb₃Sn multi-core superconducting wire produced using the precursor for Nb₃Sn single-core superconducting wire of a wire design made considering the size of the hard phase of the Sn-based wire rod, the size in the width direction of the Sn-based wire rod, the size of the thickness of the Nb-based tube, etc., the cracking and breakage of the Nb-based tube occurring during wire drawing is suppressed, and thus a decline in superconducting characteristic is suppressed. For this reason, even at production conditions of a conventional Nb₃Sn superconducting wire, the Nb₃Sn single-core superconducting wire or the Nb₃Sn multi-core superconducting wire produced using the above-mentioned precursor for Nb₃Sn single-core superconducting wire will have superior superconducting characteristic.

Although embodiments have been explained above, the present invention is not to be limited to the above-mentioned embodiments, and includes every mode encompassed by the concept of the present invention and the scope of the claims, and can be modified in various ways within the scope of the present invention.

### EXAMPLES

Next, although Examples and Comparative Examples will be explained, the present invention is not to be limited to these Examples.

### (Examples 1 to 2 and Comparative Example 1)

A filament-like Sn-based element of 24.0 mm outside diameter was inserted into a first Cu-based tube (oxygen-free copper, purity 4N) having an outside diameter of 27.5 mm, an inside diameter of 24.5 mm and a thickness of 1.5 mm. The composition of the Sn-based element is Sn-10.0 wt% Zn containing 10.0% by mass of Zn. In addition, as a result of observing by SEM (measurement region: 1200 µm x 900 pm, measurement magnification: 100 times) for the Sn-based element at the insertion, the maximum dimension in the width direction of the hard phase in a longitudinal section parallel to the longitudinal direction was 10.0 µm. Next, the first covered wire rod was obtained by performing wire drawing with die until the wire diameter of the first Cu-based tube covering the Sn-based element became 5.1 mm. Next, a second covered wire rod was obtained by inserting the first covered wire rod into a pure Nb tube with an outside diameter of 8.2 mm, an inside diameter of 5.6 mm and a thickness of 1.3 mm. Next, the second Cu-based tube (oxygen-free copper, purity 4N) with an outside diameter of 9.7 mm, an inside diameter of 8.5 mm and a thickness of 0.6 mm covered the outer side of the second covered wire rod.

After performing wire drawing by die on the wire rod obtained in this way until the wire diameter and the cross-sectional area of the Nb-based tube in a longitudinal section of the wire rod became the values shown in Table 1, the plurality of precursors for Nb₃Sn single-core superconducting wire after hexagonal processing was inserted into the third Cu-based tube (outside diameter: 30.0 mm, inside diameter: 24.0 mm, thickness 3.0 mm, oxygen-free copper, purity: 4N), so as to arrange at the outer circumference of the Cu-based core part (length across opposite hexagonal sides: 1.6 mm, oxygen-free copper, purity: 4N). For the inside of the third Cu-based tube, the number of precursors for Nb₃Sn single-core superconducting wire, and the total cross-sectional area of the Nb-based tube in the transverse section were the values shown in Table 1.

It should be noted that the wire design was performed so that a difference in superconducting characteristic of the Nb₃Sn multi-core superconducting wire produced as described later due to a difference in the total cross-sectional area of the Nb-based tube in the transverse section does not appear, and so that the value of (cross-sectional area of Nb-based tube in transverse section per one precursor for Nb₃Sn single-core superconducting wire) x (number of precursors for Nb₃Sn single-core superconducting wire inserted into third Cu-based tube), i.e. total cross-sectional area of the Nb-based tube into the third Cu-based tube in a transverse section, become completely identical. Subsequently, the precursor for Nb₃Sn multi-core superconducting wire was obtained by performing wire drawing with die until the wire diameter became 0.8 mm.

**[Table 1]**

| | Precursor for Nb₃Sn single-core superconducting wire | | Inside of third Cu-based tube | |
|---|---|---|---|---|
| | Wire diameter (mm) | Cross-sectional area of Nb-based tube in precursor for Nb₃Sn single-core superconducting wire (mm²) | Inserted number of precursors for Nb₃Sn single-core superconducting wire (number) | Total cross-sectional area of Nb-based tube (mm²) |
| Example 1 | 1.70 | 1.10 | 100 | 110 |
| Example 2 | 2.40 | 2.20 | 50 | 110 |
| Comparative Example 1 | 1.20 | 0.55 | 200 | 110 |

For the precursor for Nb₃Sn multi-core superconducting wire, five sectioned samples obtained by cutting the length in the longitudinal direction to 2 cm were prepared, and the cross section in the longitudinal direction of the sectioned samples was surfaced by resin embedding and then polishing the sectioned samples. The surfaced section was observed by SEM (measurement area: 100 µm × 100 µm, measurement magnification: 1000 times), and the minimum dimension in the width direction of the Sn-based wire rod, the minimum thickness in the width direction of the Nb-based tube and the maximum dimension in the width direction of the hard phase were measured. In addition, the number of locations at which the occurrence of tube cracking of the Nb-based tube appeared per 10 cm was measured by observing the surfaced cross section by SEM (measurement region: 500 µm × 2 cm, measurement magnification: 200 times) along the longitudinal direction. Then, the value of the maximum dimension in the width direction of the hard phase relative to the minimum dimension in the width direction of the Sn-based wire rod (the maximum dimension in the width direction of the hard phase × 100 / the minimum dimension in the width direction of the Sn-based wire rod), and the value of the maximum dimension in the width direction of the hard phase relative to the minimum thickness in the width direction of the Nb-based tube (the maximum dimension in the width direction of the hard phase × 100 / the minimum thickness in the width direction of the Nb-based wire rod) were calculated. The results of these are shown in Table 2. It should be noted that the maximum dimension in the width direction of the hard phase was 10.0 pm, similarly to the Sn-based element at the insertion.

Next, for the precursors for Nb₃Sn multi-core superconducting wire of Examples 1 and 2 and Comparative Example 1, the heat treatment was performed at conditions of a heating temperature of 670°C and a heating time of 100 hours under an argon atmosphere to obtain an Nb₃Sn multi-core superconducting wire including a plurality of Nb₃Sn single-core superconducting wire. The evaluations described below were performed on the obtained Nb₃Sn multi-core superconducting wire. The results are shown in Table 2.

### (1) Critical Current Density (Jc)

In relation to the Nb₃Sn multi-core superconducting wire sectioned to a length of 50 mm, both ends of the wire were connected with current leads, two points separated by 5 mm in the direction of each end from the wire central part were defined as voltage taps, and the 4-terminal method measurement was performed at a tap distance of 10 mm. Electrical current flowed through the wire at conditions of temperature of 4.2 K and external magnetic field of 16T, and the voltage value generated between the above-mentioned voltage taps was monitored. The electrical current value at which the voltage value between the taps became 10 µV/m was defined as the critical current (Ic), and the value arrived at by multiplying the value, which is obtained by adding 1 to the copper ratio of the wire (volume ratio of copper relative to the Nb₃Sn multi-core superconducting wire), by the critical current (Ic), and further dividing by the wire cross-sectional area was defined as the critical current density (Jc).

### (2) Residual Resistance Ratio (RRR)

In relation to the Nb₃Sn multi-core superconducting wire sectioned to a length of 250 mm, both ends of the wire were connected with current leads, two points separated by 60 mm in the direction of each end from the wire central part were defined as voltage taps, and the 4-terminal method measurement was performed at a tap distance of 120 mm. In an external magnetic field of 0T, the value arrived at by dividing the electrical resistance (R_{273K}) between the voltage taps at the temperature of 273 K by the electrical resistance (R_{4.2K}) between the voltage taps at the temperature of 4.2 K was defined as the residual resistance ratio (RRR).

**[Table 2]**

| | Minimum dimension of Sn-based wire rod (µm) | Minimum thickness of Nb-based tube (µm) | Maximum dimension of hard phase × 100 / minimum dimension of Sn-based wire rod (%) | Maximum dimension of hard phase × 100 / minimum thickness of Nb-based tube (%) | Number of tube cracks (number / 10 cm) | Critical current density Jc (A/mm²) | Residual resistance ratio RRR |
|---|---|---|---|---|---|---|---|
| Example 1 | 22.0 | 9.2 | 45.5 | 108.7 | 6 | 950 | 100 |
| Example 2 | 31.0 | 13.0 | 32.3 | 76.9 | 1 | 1100 | 200 |
| Comparative Example 1 | 15.0 | 6.5 | 66.7 | 153.8 | 25 | 650 | 10 |

As shown in Tables 1 and 2, with Example 1, the maximum dimension in the width direction of the hard phase was 50% or less of the minimum dimension in the width direction of the Sn-based wire rod. For this reason, the contact of the hard phase with the first Cu-based tube and with the Nb-based tube arranged at the outer side of the hard phase decreases, the cracking of the Nb-based tube is suppressed, and the critical current density Jc and the residual resistance ratio RRR improved.

In addition, with Example 2 having increased the minimum dimension in the width direction of the Sn-based wire rod and the minimum thickness in the width direction of the Nb-based tube, since the value of the maximum dimension of the hard phase relative to the minimum dimension of the Sn-based wire rod became smaller, the contact of the hard phase with the first Cu-based tube and with the Nb-based tube decreasing, and further since the maximum dimension in the width direction of the hard phase was equal to or smaller than the minimum thickness in the width direction of the Nb-based tube, even if the hard phase and the Nb-based tube are contacted, the tube cracking tends not to occur at the contact point thereof, and therefore a result of which the number of tube cracks further decreased. As a result thereof, the critical current density Jc and the residual resistance ratio RRR further increased.

On the other hand, with Comparative Example 1, since the maximum dimension of the hard phase was larger than 50% of the minimum dimension of the Sn-based wire rod, the contact of the hard phase with the first Cu-based tube and with the Nb-based tube increasing, in addition to the maximum dimension of the hard phase was larger than the minimum thickness of the Nb-based tube. For this reason, as a result of cracking frequently occurring at the contact point between the hard phase and the Nb-based tube, the critical current density Jc and the residual resistance ratio RRR both declined.

In this way, in Example 1 and Example 2, the critical current density Jc and the residual resistance ratio RRR both increased accompanying the cracking of the Nb-based tube decreasing. The factors for the increase in such superconducting characteristic are due to leakage of Sn component to the second Cu-based tube at the tube cracking portion occurring in Comparative Example 1 being suppressed by the decrease in the number of tube cracks per unit length, and due to division in the longitudinal direction of Nb₃Sn, which is the superconducting portion, occurring in Comparative Example 1 being suppressed.

The above-mentioned Examples 1 and 2 show that suppression of cracks of the Nb-based tube and improvements in Jc and RRR are possible in the case of increasing the Nb-based tube thickness and the Sn-based wire rod diameter after multi-core wire finishing; however, in the case of making the Nb-based tube thickness or the Sn-based wire rod diameter extremely large (case of the superconducting filament diameter being extremely thick), the alternating current loss upon using under an AC electric field significantly rises, and the decrease in efficiency and the increase in cooling load of equipment using the Nb₃Sn multi-core superconducting wire occur. During wire design, the size of the hard phase in the Sn-based wire rod used is confirmed, and it is good if designing so that the filament diameter is made as small as possible within a range in which the above-mentioned such size of the hard phase, size of the Sn-based wire rod and size of the Nb-based tube satisfy a desired relationship, suppressing the occurrence risk of Nb-based tube cracks.

### (Examples 3 to 5 and Comparative Example 2)

Contrary to Examples 1 and 2 and Comparative Example 1 which fixed the size of the hard phase using the same type of Sn-based element, and changed the size of the precursor for Nb₃Sn single-core superconducting wire and/or the inserted number of precursors for Nb₃Sn single-core superconducting wire, thereby changing the minimum dimension in the width direction of the Sn-based wire rod and the minimum thickness in the width direction of the Nb-based tube, with Examples 3 to 5 and Comparative Example 2, the size of the precursor for Nb₃Sn single-core superconducting wire and the inserted number of precursors for Nb₃Sn single-core superconducting wire were fixed, and the size of the hard phase was changed, thereby changing the minimum dimension in the width direction of the Sn-based wire rod and the minimum thickness in the width direction of the Nb-based tube. It should be noted that Sn-based elements for which the dimension of the hard phase is intentionally controlled are used herein. In other words, as stated in the embodiment, with the Sn-based elements of the compositions used in Examples 3 to 5 and Comparative Example 2, the hard phase with small dimension can be easily formed. However, to investigate the influence that the dimension of the hard phase has on superconducting characteristic, the dimension of the hard phase was intentionally made larger, even if an Sn-based element of Sn-1.0 wt% Ti, as in Comparative Example 2, for example.

First, the filament-like Sn-based element of the composition shown in Table 3 having an outside diameter of 24.0 mm was inserted into the first Cu-based tube (oxygen-free copper, purity 4N) having an outside diameter of 27.5 mm, an inside diameter of 24.5 mm and a thickness of 1.5 mm. In addition, for the Sn-based element at the insertion, the maximum dimension in the width direction of the hard phase in a longitudinal section parallel to the longitudinal direction was the value shown in Table 3, as a result of observing by SEM similarly to as described above. Next, for the first Cu-based tube covering the Sn-based element, wire drawing by die was performed until the wire diameter became 4.8 mm to obtain the first covered wire rod. Next, the first covered wire rod was inserted into a pure Nb tube having an outside diameter of 8.2 mm, an inside diameter of 5.5 mm and a thickness of 1.35 mm to obtain a second covered wire rod. Next, the second Cu-based tube (oxygen-free copper, purity 4N) having an outside diameter of 9.7 mm, an inside diameter of 8.5 mm and a thickness of 0.6 mm covered the outer side of the second covered wire rod.

After performing wire drawing by die on the wire rod obtained in this way until the length across opposite hexagonal sides become 1.57 mm, 132 of the precursors for Nb₃Sn single-core superconducting wire after hexagonal processing were inserted into the third Cu-based tube (outside diameter: 30.0 mm, inside diameter: 24.0 mm, thickness: 3.0 mm, oxygen-free copper, purity 4N) so as to arrange at the outer circumference of the Cu-based core part (length across opposite hexagonal sides: 1.57 mm, oxygen-free copper, purity: 4N). Subsequently, wire drawing by die was performed until the wire diameter became 0.8 mm to obtain the precursor for Nb₃Sn multi-core superconducting wire.

Various dimensions were measured for the precursor for Nb₃Sn multi-core superconducting wire similarly to as described above. The measurement results are shown in Table 3. The minimum dimension in the width direction of the Sn-based wire rod was 16.0 pm, the minimum thickness in the width direction of the Nb-based tube was 12.0 µm, and the ratio (S_{Nb}/S_{Sn}) of the cross-sectional area S_{Nb} of the Nb-based tube relative to the cross-sectional area S_{Sn} of the Sn-based wire rod in the longitudinal section of the precursor for Nb₃Sn multi-core superconducting wire was 2.5. In addition, the maximum dimension in the width direction of the hard phase was similar to the Sn-based element at the insertion.

Next, the heat treatment similar to that described above was performed on the precursor for Nb₃Sn multi-core superconducting wire to prepare an Nb₃Sn multi-core superconducting wire, and the superconducting characteristic thereof was measured similarly to as described above. The results are shown in Table 3.

**[Table 3]**

| | Sn-based element | Maximum dimension of hard phase (µm) | Maximum dimension of hard phase × 100 / minimum dimension of Sn-based wire rod (%) | Maximum dimension of hard phase × 100 / minimum thickness of Nb-based tube (%) | Number of tube cracks (number / 10 cm) | Critical current density Jc (A/mm²) | Residual resistance ratio RRR |
|---|---|---|---|---|---|---|---|
| Example 3 | Sn-10.0wt%Zn | 10.0 | 62.5 | 83.3 | 10 | 850 | 30 |
| Example 4 | Sn-1.0wt%Hf | 6.0 | 37.5 | 50.0 | 2 | 1000 | 100 |
| Example 5 | Sn-0.5wt%Cu | 3.0 | 18.8 | 25.0 | 0 | 1100 | 200 |
| Comparative Example 2 | Sn-1.0wt%Ti | 15.0 | 93.8 | 125.0 | 35 | 600 | 5 |

As shown in Table 3, with Example 3 in which the maximum dimension of the hard phase was 10.0 pm, since the maximum dimension of the hard phase was larger than 50% of the minimum dimension of the Sn-based wire rod, although contact of the hard phase with the first Cu-based tube and with the Nb-based tube was the same as conventional, the maximum dimension of the hard phase was equal to or smaller than the minimum thickness of the Nb-based tube. For this reason, even if the hard phase and the Nb-based tube contact, the tube cracking at this contact point tends not to occur, and the tube cracking is suppressed.

In addition, with Example 4 in which the maximum dimension of the hard phase was 6.0 µm, since the maximum dimension of the hard phase was smaller than 50% of the minimum dimension of the Sn-based wire rod, the contact points of the hard phase with the first Cu-based tube and with the Nb-based tube decreased. Furthermore, the value of the maximum dimension of the hard phase relative to the minimum thickness of the Nb-based tube became even smaller. For this reason, the number of tube cracks at the contact point between the hard phase and the Nb-based tube further decreased.

In addition, with Example 5 in which the maximum dimension of the hard phase was 3.0 µm, by making the maximum dimension of the hard phase smaller than 20.0% of the minimum dimension of the Sn-based wire rod, the hard phase made entirely no contact with the first Cu-based tube and with the Nb-based tube. For this reason, the tube cracks per 10 cm length was not observed.

In this way, in Examples 3 to 5, accompanying a decrease in the maximum dimension of the hard phase, the tube crack number decreased, and the critical current density Jc and the residual resistance ratio RRR both increased. Factors for such an increase in superconducting characteristic are due to the leakage of Sn component to the second Cu-based tube, which is arranged at the outer side of the Nb-based tube, being suppressed by the decrease in the number of tube cracks, and due to division in the longitudinal direction of Nb₃Sn, which is the superconducting portion, being suppressed.

On the other hand, with Comparative Example 2 in which the maximum dimension of the hard phase was 15.0 pm, since the maximum dimension of the hard phase was larger than 50% of the minimum dimension of the Sn-based wire rod, contact of the hard phase with the first Cu-based tube and with the Nb-based tube increased. Furthermore, the maximum dimension of the hard phase was larger than the minimum thickness of the Nb-based tube. For this reason, the tube cracking at the contact point between the hard phase and the Nb-based tube frequently occurred.

In this way, in Comparative Example 2, the tube crack number increased by the increase in maximum dimension of the hard phase, and the critical current density Jc and the residual resistance ratio RRR both declined. The factors for such a decline in superconducting characteristic are as follows. The decline in the critical current density Jc is because; in addition to the generated amount of Nb₃Sn which is the superconducting component decreasing during the heat treatment for producing Nb₃Sn, by the Sn component more preferentially undergoing diffusional reaction with the Cu component of the second Cu-based tube, which is at the outer side of the Nb-based tube, than the Nb component of the Nb-based tube at the portion at which the tube cracking of the Nb-based tube occurred; the compositional deviation from the stoichiometric ratio occurs due to Sn deficiency of the obtained Nb₃Sn. In addition, the critical current density Jc declined also due to the Nb₃Sn being divided in the longitudinal direction. In addition, the decline in the residual resistance ratio RRR is because, at the tube cracking portion of the Nb-based tube, the second Cu-based tube originally functioning as a stabilizing material is contaminated by the leakage of Sn component, and the Sn component reacts with the Cu component of the second Cu-based tube, which is at the outer side of the Nb-based tube, and bronzes.

1 precursor for Nb₃Sn single-core superconducting wire
2 precursor for Nb₃Sn multi-core superconducting wire
10 Sn-based wire rod
11 matrix phase
12 hard phase
20 first Cu-based tube
30 Nb-based tube
40 second Cu-based tube
50 Cu-based core part
51 Cu-based wire rod
60 multilayer wire rod part
70 third Cu-based tube
80 Cu-based spacer part
81 Cu-based wire rod

## Claims

1. A precursor (1) for Nb₃Sn single-core superconducting wire comprising: a Sn-based wire rod (10), a first Cu-based tube (20) covering an outer circumferential surface of the Sn-based wire rod (10), an Nb-based tube (30) covering an outer surface of the first Cu-based tube (20), and a second Cu-based tube (40) covering an outer surface of the Nb-based tube (30),
wherein the Sn-based wire rod (10) contains a matrix phase (11) and at least one kind of hard phase (12) which is harder than the matrix phase (11), and
wherein, in a cross section parallel to a longitudinal direction of the precursor (1) for Nb₃Sn single-core superconducting wire, a maximum dimension of the hard phase (12) in a width direction perpendicular to the longitudinal direction is 50% or less of a minimum dimension in the width direction of the Sn-based wire rod and/or is equal to or smaller than a minimum thickness in the width direction of the Nb-based tube (30).

2. The precursor for Nb₃Sn single-core superconducting wire according to claim 1, wherein the Sn-based wire rod (10) contains a total of 10.0% by mass or less of at least one kind of element selected from the group consisting of Ti, Cu, Hf, Zn, Zr and Al.

3. The precursor for Nb₃Sn single-core superconducting wire according to claim 1 or 2, wherein the maximum dimension of the hard phase (12) in the cross section is 40% or less of the minimum dimension of the Sn-based wire rod (10).

4. The precursor for Nb₃Sn single-core superconducting wire according to any one of claims 1 to 3, wherein the maximum dimension of the hard phase (12) in the cross section is 20% or less of the minimum dimension of the Sn-based wire rod (10).

5. The precursor for Nb₃Sn single-core superconducting wire according to any one of claims 1 to 4, wherein, in the cross section, a ratio (S_{Nb}/S_{Sn}) of a cross sectional area S_{Nb} of the Nb-based tube (30) relative to a cross sectional area S_{Sn} of the Sn-based wire rod (10) is 2.0 or more and 4.0 or less.

6. A method for producing a precursor (1) for Nb₃Sn single-core superconducting wire, the method comprising the steps of:
forming a first covered wire rod in which a first Cu-based tube (20) covers with an outer circumferential surface of an Sn-based wire rod (10) obtained by drawing a filament-like Sn-based element, made by inserting the filament-like Sn-based element into the first Cu-based tube (20) and then performing wire drawing; obtaining a second covered wire rod by inserting the first covered wire rod into an Nb-based tube (30); and
inserting the second covered wire rod into a second Cu-based tube (40) and then performing wire drawing,
wherein the Sn-based wire rod (10) contains a matrix phase (11) and at least one kind of hard phase (12) which is harder than the matrix phase (11), and
wherein, in a cross section parallel to a longitudinal direction of the precursor for Nb₃Sn single-core superconducting wire, a maximum dimension of the hard phase (12) in a width direction perpendicular to the longitudinal direction is 50% or less of a minimum dimension in the width direction of the Sn-based wire rod (10) and/or is equal to or smaller than a minimum thickness in the width direction of the Nb-based tube (30).

7. An Nb₃Sn single-core superconducting wire comprising a heating product of the precursor for Nb₃Sn single-core superconducting wire according to any one of claims 1 to 5.

8. A precursor for Nb₃Sn multi-core superconducting wire, comprising:
a Cu-based core part (50) made by bundling a plurality of Cu-based wire rods;
a multilayer wire rod part (60) by arranging a plurality of the precursors for Nb₃Sn single-core superconducting wire according to any one of claims 1 to 5 with a plurality of layers over an outer circumferential side of the Cu-based core part (50); and
a third Cu-based tube (70) covering an outer circumference of the multilayer wire rod part.

9. A method for producing a precursor for Nb₃Sn multi-core superconducting wire, the method comprising a step of inserting, into a third Cu-based tube (70), a Cu-based core part (50) made by bundling a plurality of Cu-based wire rods, and a multilayer wire rod part (60) having a plurality of the precursors for Nb₃Sn single-core superconducting wire according to any one of claims 1 to 5 arranged with a plurality of layers over an outer circumferential side of the Cu-based core part, and then performing wire drawing.

10. An Nb₃Sn multi-core superconducting wire comprising a heating product of the precursor for Nb₃Sn multi-core superconducting wire according to claim 8.

## Patentansprüche

1. Vorläufer (1) für einadrigen supraleitenden Nb₃Sn-Draht, umfassend: einen Walzdraht (10) auf Sn-Basis, ein erstes Rohr (20) auf Cu-Basis, das eine äußere Umfangsfläche des Walzdrahtes (10) auf Sn-Basis umgibt, ein Rohr (30) auf Nb-Basis, das eine äußere Oberfläche des ersten Rohres (20) auf Cu-Basis umgibt, und ein zweites Rohr (40) auf Cu-Basis, das eine äußere Oberfläche des Rohres (30) auf Nb-Basis umgibt,
wobei der Walzdraht (10) auf Sn-Basis eine Matrixphase (11) und mindestens eine Art von Hartphase (12) enthält, die härter ist als die Matrixphase (11), und
wobei in einem Querschnitt parallel zu einer Längsrichtung des Vorläufers (1) für einadrigen supraleitenden Nb₃Sn-Draht eine maximale Dimension der Hartphase (12) in einer Breitenrichtung senkrecht zur Längsrichtung 50% oder weniger einer minimalen Dimension in der Breitenrichtung des Walzdrahtes auf Sn-Basis beträgt und/oder gleich oder kleiner als eine minimale Dicke in der Breitenrichtung des Rohres (30) auf Nb-Basis ist.

2. Vorläufer für einadrigen supraleitenden Nb₃Sn-Draht gemäß Anspruch 1, wobei der Walzdraht (10) auf Sn-Basis insgesamt 10,0 Massenprozent oder weniger mindestens einer Art von Element enthält, das aus der Gruppe bestehend aus Ti, Cu, Hf, Zn, Zr und Al ausgewählt ist.

3. Vorläufer für einadrigen supraleitenden Nb₃Sn-Draht gemäß Anspruch 1 oder 2, wobei die maximale Dimension der Hartphase (12) im Querschnitt 40% oder weniger der minimalen Dimension des Walzdrahtes (10) auf Sn-Basis beträgt.

4. Vorläufer für einadrigen supraleitenden Nb₃Sn-Draht gemäß einem der Ansprüche 1 bis 3, wobei die maximale Dimension der Hartphase (12) im Querschnitt 20% oder weniger der minimalen Dimension des Walzdrahtes (10) auf Sn-Basis beträgt.

5. Vorläufer für einadrigen supraleitenden Nb₃Sn-Draht gemäß einem der Ansprüche 1 bis 4, wobei im Querschnitt ein Verhältnis (S_{Nb}/S_{Sn}) einer Querschnittsfläche S_{Nb} des Rohres (30) auf Nb-Basis relativ zu einer Querschnittsfläche S_{Sn} des Walzdrahtes (10) auf Sn-Basis 2,0 oder mehr und 4,0 oder weniger beträgt.

6. Verfahren zum Herstellen eines Vorläufers (1) für einen einadrigen supraleitenden Nb₃Sn-Draht, wobei das Verfahren die folgenden Schritte umfasst:
Bilden eines ersten umhüllten Walzdrahtes, bei dem ein erstes Rohr (20) auf Cu-Basis eine äußere Umfangsfläche eines Walzdrahtes (10) auf Sn-Basis bedeckt, der durch Ziehen eines fadenförmigen Elementes auf Sn-Basis erhalten wird, das durch Einsetzen des fadenförmigen Elementes auf Sn-Basis in das erste Rohr (20) auf Cu-Basis und anschließendes Drahtziehen hergestellt wird;
Erhalten eines zweiten umhüllten Walzdrahtes durch Einsetzen des ersten umhüllten Walzdrahtes in ein Rohr (30) auf Nb-Basis; und
Einsetzen des zweiten umhüllten Walzdrahtes in ein zweites Rohr (40) auf Cu-Basis und anschließendes Ziehen des Drahtes,
wobei der Walzdraht (10) auf Sn-Basis eine Matrixphase (11) und mindestens eine Art von Hartphase (12) enthält, die härter ist als die Matrixphase (11), und
wobei in einem Querschnitt parallel zu einer Längsrichtung des Vorläufers für einen einadrigen supraleitenden Nb₃Sn-Draht eine maximale Dimension der Hartphase (12) in einer Breitenrichtung senkrecht zu der Längsrichtung 50% oder weniger einer minimalen Dimension in der Breitenrichtung des Walzdrahtes (10) auf Sn-Basis beträgt und/oder gleich oder kleiner als eine minimale Dicke in der Breitenrichtung des Rohres (30) auf Nb-Basis ist.

7. Einadriger supraleitender Nb₃Sn-Draht, der ein Heizprodukt des Vorläufers für einadrigen supraleitenden Nb₃Sn-Draht gemäß einem der Ansprüche 1 bis 5 umfasst.

8. Vorläufer für mehradrigen, supraleitenden Nb₃Sn-Draht, umfassend:
ein Aderteil (50) auf Cu-Basis, der durch Bündelung einer Vielzahl von Wahlzdrähten auf Cu-Basis hergestellt wird;
ein mehrschichtiges Walzdrahtteil (60) durch Anordnen einer Vielzahl der Vorläufer für einen einadrigen supraleitenden Nb₃Sn-Draht gemäß einem der Ansprüche 1 bis 5 mit einer Vielzahl von Schichten über einer äußeren Umfangsseite des Aderteils auf Cu-Basis (50); und
ein drittes Rohr (70) auf Cu-Basis, das einen äußeren Umfang des mehrschichtigen Walzdrahtteils bedeckt.

9. Verfahren zum Herstellen eines Vorläufers für einen mehradrigen supraleitenden Nb₃Sn-Draht, wobei das Verfahren einen Schritt des Einsetzens, in ein drittes Rohr (70) auf Cu-Basis, eines Aderteils (50) auf Cu-Basis, der durch Bündeln einer Vielzahl von Walzdrähten auf Cu-Basis hergestellt ist, und eines mehrschichtigen Walzdrahtteils (60), der eine Vielzahl der Vorläufer für einen einadrigen supraleitenden Nb₃Sn-Draht gemäß einem der Ansprüche 1 bis 5 hat, die mit einer Vielzahl von Schichten auf einer äußeren Umfangsseite des Aderteils auf Cu-Basis angeordnet sind, umfasst und anschließendes Ziehen des Drahtes erfolgt.

10. Mehradriger supraleitender Nb₃Sn-Draht, umfassend ein Heizprodukt des Vorläufers für mehrschichtigen supraleitenden Nb₃Sn-Draht gemäß Anspruch 8.

## Revendications

1. Précurseur (1) pour fil supraconducteur à noyau unique de Nb₃Sn comprenant : un fil machine à base de Sn (10), un premier tube à base de Cu (20) recouvrant une surface circonférentielle externe du fil machine à base de Sn (10), un tube à base de Nb (30) recouvrant une surface externe du premier tube à base de Cu (20), et un deuxième tube à base de Cu (40) recouvrant une surface externe du tube à base de Nb (30),
dans lequel le fil machine à base de Sn (10) contient une phase matricielle (11) et au moins un type de phase dure (12) qui est plus dure que la phase matricielle (11), et
dans lequel, dans une section transversale parallèle à une direction longitudinale du précurseur (1) pour fil supraconducteur à noyau unique de Nb₃Sn, une dimension maximale de la phase dure (12) dans une direction de largeur perpendiculaire à la direction longitudinale fait 50 % ou moins d'une dimension minimale dans la direction de largeur du fil machine à base de Sn et/ou est égale ou inférieure à une épaisseur minimale dans la direction de largeur du tube à base de Nb (30).

2. Précurseur pour fil supraconducteur à noyau unique de Nb₃Sn selon la revendication 1, dans lequel le fil machine à base de Sn (10) contient un total de 10,0 % en masse ou moins d'au moins un type d'élément sélectionné dans le groupe consistant en Ti, Cu, Hf, Zn, Zr et Al.

3. Précurseur pour fil supraconducteur à noyau unique de Nb₃Sn selon la revendication 1 ou 2, dans lequel la dimension maximale de la phase dure (12) dans la section transversale fait 40 % ou moins de la dimension minimale du fil machine à base de Sn (10).

4. Précurseur pour fil supraconducteur à noyau unique de Nb₃Sn selon l'une quelconque des revendications 1 à 3, dans lequel la dimension maximale de la phase dure (12) dans la section transversale fait 20 % ou moins de la dimension minimale du fil machine à base de Sn (10).

5. Précurseur pour fil supraconducteur à noyau unique de Nb₃Sn selon l'une quelconque des revendications 1 à 4, dans lequel, dans la section transversale, un rapport (S_{Nb}/S_{Sn}) d'une aire de section transversale S_{Nb} du tube à base de Nb (30) par rapport à une aire de section transversale S_{Sn} du fil machine à base de Sn (10) est de 2,0 ou plus et de 4,0 ou moins.

6. Procédé de production d'un précurseur (1) pour fil supraconducteur à noyau unique de Nb₃Sn, le procédé comprenant les étapes consistant à :
former un premier fil machine recouvert dans lequel un premier tube à base de Cu (20) recouvre une surface circonférentielle externe d'un fil machine à base de Sn (10) obtenu en étirant un élément à base de Sn de type filament, réalisé en insérant l'élément à base de Sn de type filament dans le premier tube à base de Cu (20), puis effectuer un tréfilage ;
obtenir un second fil machine recouvert en insérant le premier fil machine recouvert dans un tube à base de Nb (30) ; et
insérer le second fil machine recouvert dans un second tube à base de Cu (40), puis effectuer un tréfilage,
dans lequel le fil machine à base de Sn (10) contient une phase matricielle (11) et au moins un type de phase dure (12) qui est plus dure que la phase matricielle (11), et dans lequel, dans une section transversale parallèle à une direction longitudinale du précurseur pour fil supraconducteur à noyau unique de Nb₃Sn, une dimension maximale de la phase dure (12) dans une direction de largeur perpendiculaire à la direction longitudinale fait 50 % ou moins d'une dimension minimale dans la direction de largeur du fil machine à base de Sn (10) et/ou est égale ou inférieure à une épaisseur minimale dans la direction de largeur du tube à base de Nb (30).

7. Fil supraconducteur à noyau unique de Nb₃Sn comprenant un produit chauffant du précurseur pour fil supraconducteur à noyau unique de Nb₃Sn selon l'une quelconque des revendications 1 à 5.

8. Précurseur pour fil supraconducteur à noyau unique de Nb₃Sn, comprenant :
une partie noyau à base de Cu (50) fabriquée en regroupant une pluralité de fils machine à base de Cu ;
une partie fil machine multicouche (60) en agençant une pluralité des précurseurs pour fil supraconducteur à noyau unique de Nb₃Sn selon l'une quelconque des revendications 1 à 5 avec une pluralité de couches sur un côté circonférentiel externe de la partie noyau à base de Cu (50) ; et
un troisième tube à base de Cu (70) recouvrant une circonférence externe de la partie de fil machine multicouche.

9. Procédé de production d'un précurseur pour fil supraconducteur à noyau unique de Nb₃Sn, le procédé comprenant une étape consistant à insérer, dans un troisième tube à base de Cu (70), une partie noyau à base de Cu (50) fabriquée en regroupant une pluralité de fils machine à base de Cu, et une partie fil machine multicouche (60) présentant une pluralité des précurseurs pour fil supraconducteur à noyau unique de Nb₃Sn selon l'une quelconque des revendications 1 à 5, disposés avec une pluralité de couches sur un côté circonférentiel externe de la partie noyau à base de Cu, puis effectuer un tréfilage.

10. Fil supraconducteur à noyau unique de Nb₃Sn comprenant un produit chauffant du précurseur pour fil supraconducteur à noyau unique de Nb₃Sn selon la revendication 8.
